# EUROPEAN PATENT SPECIFICATION

(11) **EP 3 406 406 B1**
(45) Date of publication and mention of the grant of the patent: **03.07.2024**
(21) Application number: 16834953.8
(22) Date of filing: 25.07.2016
(51) Int. Cl.: B25J 9/06, B25J 9/04, B25J 18/04, H01L 21/677

(54) **INDUSTRIAL ROBOT**
INDUSTRIEROBOTER
ROBOT INDUSTRIEL

(30) Priority: 07.08.2015 US 201562202450 P; 22.01.2016 JP 2016010904; 22.01.2016 JP 2016010905
(43) Date of publication of application: 28.11.2018
(60) Divisional application: 20200465.1
(73) Proprietor: Nidec Sankyo Corporation, Suwa-gun, Nagano 393-8511 (JP)
(72) Inventor: SHIRAKI, Takahiro, Nagano 393-8511 (JP); KITAHARA, Yasuyuki, Nagano 393-8511 (JP); KURIBAYASHI, Tamotsu, Nagano 393-8511 (JP); NAKAE, Takao, Nagano 393-8511 (JP); KAINO, Shigeyuki, Nagano 393-8511 (JP)
(74) Representative: Becker Kurig & Partner Patentanwälte mbB
(86) International application number: PCT/JP2016/071711
(87) International publication number: WO 2017/026256

(56) References cited:
- JP-A- H11 156 772
- JP-A- 2000 117 670
- JP-A- 2002 338 042
- JP-A- 2002 338 042
- JP-A- 2003 526 193
- JP-A- 2003 526 193
- JP-A- 2014 042 049
- JP-A- 2014 111 310
- JP-A- 2014 111 310
- JP-A- 2014 229 730
- KR-B1- 101 312 821
- US-A- 5 178 512
- US-A1- 2013 323 002

## Description

### [Field of Technology]

The present invention relates to an industrial robot for transferring objects-to-be-transferred such as semiconductor wafers.

### [Background of Technology]

Conventionally known is an horizontally articulated robot for transferring semiconductor wafers between a FOUP (Front Open Unified Pod) and a semiconductor processing device (Unexamined Japanese Patent Application 2015-36186 Publication, for example). A horizontally articulated robot disclosed in Unexamined Japanese Patent Application 2015-36186 Publication configures part of an EFEM (Equipment Front End side Module) and is arranged inside an EFEM housing. The EFEM is arranged on the front side of the semiconductor processor while the FOUP is arranged on the front side of the EFEM. The EFEM housing is formed in a rectangular box which has its shorter-length direction in the front-rear direction and its longer-length direction in the left-right direction.

The horizontally articulated robot disclosed in Unexamined Japanese Patent Application 2015-36186 Publication is provided with two hands on which semiconductor wafers are to be mounted, an arm to which the two hands are rotatably joined to the front end side thereof, and a main body portion to which the base end side of the arm is rotatably joined. The arm is configured by a first arm portion, of which the base end side is rotatably joined to the main body portion, a second arm portion, of which the base end side is rotatably joined to the front end side of the first arm portion, and a third arm portion, of which the base end side is rotatably joined to the front end side of the second arm portion and to which the hands are rotatably attached to the front end side thereof. The main body portion is provided with a column member, to which the base end side of the arm (that is, the base end side of the first arm portion) is rotatably joined to the top end thereof, a housing which holds the column member to be able to elevate, and an elevating mechanism which raises/lowers the column member. The column member is housed in the housing when lowered. Also, the elevating mechanism is housed inside the housing. Even when the column member is elevated, the bottom portion of the column member is inside the housing.

The housing is formed such that the shape thereof is square when viewed from the top-bottom direction; the front and rear surfaces of the housing are formed to be planar and intersect orthogonally with the front-rear direction; the left and right surfaces of the housing are formed to be planar and intersect orthogonally with the left-right direction. When viewed from the top-bottom direction, the column member is inside the outward form of the housing. When viewed from the top-bottom direction, the column member is in the center position in the left-right direction of the housing. Also, the column member is on the front side of the housing in the front-rear direction when viewed from the top-bottom direction. In other words, the base end side of the arm joined to the column member is positioned on the front side of the housing.

The horizontally articulated robot disclosed in Unexamined Japanese Patent Application 2015-36186 Publication is arranged in the EFEM housing such that the inside front surface of the EFEM housing is adjacent to the front surface of the housing of the horizontally articulated robot. In other words, the horizontally articulated robot is positioned inside the EFEM housing such that the base end side of the arm joined to the column member is adjacent to the inside front surface of the EFEM housing. For this reason, in an semiconductor fabrication system in which the horizontally articulated root is installed, it is possible to prevent the interference between the inside front and rear surfaces of the EFEM housing and the arm while ensuring the lengths of the first arm portion, the second arm portion and the third arm portion.

### [Related art reference]

### [Patent reference]

US 2013/323002 A1 discloses a transfer robot including an arm unit, a base unit, a guide unit, a lifting unit, and a vent part. The arm unit includes a robot hand capable of holding an object to be transferred. The base unit is formed into a substantially box shape. The guide unit includes a vertical shaft vertically arranged in the base unit. The lifting unit is provided to be raisable and lowerable along the vertical shaft and supports the arm unit at an upper end portion. The vent part is opened in an upper surface of the base unit and vents downflow from an outside to an inside of the base unit.

JP H11 156772 A discloses a robot having a fixing part 10; a lower step movable part 20 and an upper step movable part 30 movable up and down to the fixing part 10; and a hand part 40 provided at the upper side of the upper step movable part 30. A flange part 12 is provided to the upper part of the fixing part 10, and the robot 1 is supported by fixing the flange part 12 to a frame 3. And a regulation screw to regulate the horizontal condition of the substrate installing surface of the hand 43 of a hand part 40 is provided to the flange part 12, and the centering of the hand 43 is carried out by regulating the regulation screw in the robot setting time. In the lower step movable part 20 and the upper step movable part 30, a rack and a pinion are operated by a motor fixed to the fixing part 10, and the upper step movable part 30 is moved up and down at the stroke larger than the lower step movable part 20.

KR 101 312 821 B1 discloses a substrate transfer apparatus including a body; a lifting mechanism for lifting inside the body; and a movable part connected to the lifting mechanism, capable of relative movement with respect to the lifting mechanism, and capable of transferring a substrate; wherein the lifting mechanism includes a driving part for driving the movable part; a housing provided outside the driving part; an opening for communicating an outer space of the housing with a space in which the driving part is located, and a cover member covering the opening, and when the lifting mechanism is lifted to a specific position, the cover member is pulled out of the body.

### [Summary of the Invention]

### [Problems to be Solved and Objective to be Achieved]

As described above, the horizontally articulated robot disclosed in Unexamined Japanese Patent Application 2015-36186 Publication is positioned inside the EFEM housing. Various kinds of piping and cables may be routed inside the EFEM housing. To ensure a space for routing pipes and cables, it is preferred that the main body portion of the horizontally articulated robot be made thinner in the front-rear direction.

Various kinds of pipes or cables may be routed inside the EFEM housing in which the horizontally articulated robot disclosed in Unexamined Japanese Patent Application 2015-36186 Publication is installed. However, to prevent the interference between the inside front and rear surfaces of the EFEM housing and the arm while ensuring the lengths of the first arm portion, the second arm portion and the third arm portion, the horizontally articulated robot disclosed in Unexamined Japanese Patent Application 2015-36186 Publication is installed inside the EFEM housing such that the inside front surface of the EFEM housing is adjacent to the base end side of the arm of the horizontally articulated robot; thus, the inside front surface of the EFEM housing and the front surface of the housing of the horizontally articulated robot are adjacent to each other. Therefore, it is difficult, in the EFEM housing in which the horizontally articulated robot disclosed in Unexamined Japanese Patent Application 2015-36186 Publication is installed, to route pipes and cables along the inside front surface of the EFEM housing; as a result, flexibility in routing pipes and cables is decreased.

An objective of the present invention, then, is to provide an industrial robot in which a main body portion, to which the base end portion of an arm is rotatably joined, can be made thinner.

Another objective of the present invention is to provide an industrial robot in which flexibility in routing pipes and cables inside an EFEM housing can be increased even when the base end side of the arm is positioned adjacently to the side surface on the inside of the EFEM housing.

### [Means to Achieve Objectives]

To achieve the above described objectives, an industrial robot of the present invention is provided with hands on which objects-to-be-transferred are to be mounted, an arm, to which the hand is rotatably joined to the front end side thereof, and a main body portion, to which the base end side of the arm is rotatably joined; the main body portion is provided with an elevating unit, to which the base end side of the arm is rotatably joined to the top portion thereof, a housing which holds the elevating unit to be raised and lowered and in which at least part of at the bottom end side of the elevating unit is housed, and an elevating mechanism for raising/lowering the elevating unit; the elevating mechanism is provided with a motor, a ball screw, a first pulley secured to an output shaft of the motor, a second pulley secured to a screw shaft of the ball screw, and a belt hung around the first pulley and the second pulley. The elevating mechanism is stored in the housing such that it aligns with the elevating unit when viewed from the top-bottom direction. The motor is positioned in the center of the housing in the left-right direction, and the screw shaft is positioned on the right side of the motor. The motor and the ball screw are positioned in the housing so as to be adjacent to each other in the left-right direction.

In the present invention, for example, the housing is formed to be in a rectangular shape having the longer direction in the left-right direction and the shorter direction in the front-rear direction when viewed from the top-bottom direction; the elevating unit is formed to be in a rectangular shape having he longer direction in the left-right direction and the shorter direction in the front-rear direction when viewed from the top-bottom direction, and is provided with a frame portion which is housed in the housing when the elevating unit is lowered.

In the industrial robot of the present invention, the main body portion is provided with the elevating unit, which the base end side of the arm is rotatably joined to the top portion thereof, the housing, in which at least part of the bottom end side of the elevating unit is housed, and the elevating mechanism for raising/lowering the elevating unit; the elevating mechanism is stored in the housing such that it aligns with the elevating unit when viewed from the top-bottom direction. For this reason, when the housing is formed to be in a rectangular shape having the longer direction in the left-right direction and the shorter direction in the front-rear direction when viewed from the top-bottom direction as in the present invention, the width of the housing in the front-rear direction can be reduced, compared to the configuration in which the elevating mechanism is housed in the housing such that it is out of alignment with the elevating unit in the front-rear direction. In other words, compared to the configuration in which the elevating mechanism is stored in the housing while out of alignment with the elevating unit in the front-rear direction, the width of the main body portion in the front-rear direction can be shortened in the present invention; as a result, the main body unit can be made thinner.

In the present invention, it is preferred that the main body unit be provided with a guide mechanism which has a guide rail and a guide block that engages with the guide rail to guide the elevating unit in the top-bottom direction, and that the guide rail and the guide block be arranged at the both outsides of the frame portion in the left-right direction and housed inside the housing. With this configuration, it is possible to increase the distance between the guide rail and the guide block arranged on the left side of the frame portion and the guide rail and the guide block arranged on the right side of the frame portion. Therefore, it is possible that the elevating unit can smoothly be guided by the guide mechanism.

### [Means to Achieve Objectives]

The present disclosure further relates to an industrial robot not part of the present invention which is provided with hands on which objects-to-be-transferred are to be mounted, an arm, to which the hand is rotatably joined to the front end side thereof, and a main body portion, to which the base end side of the arm is rotatably joined; the main body portion is provided with an elevating unit, to which the base end side of the arm is rotatably joined to the top portion thereof, a housing which holds the elevating unit to be raised and lowered and in which at least part of the bottom side of the elevating unit is housed; the elevating unit is provided with a protruding portion protruding toward one side of the horizontal direction above the top end thereof, and is rotatably joined to the protruding portion.

In said industrial robot of the disclosure, the elevating unit has the protruding portion protruding toward one side of the horizontal direction at the top end thereof, and the base end side of the arm is positioned above the top end of the protruding portion and rotatably joined to the protruding portion. For this reason, for example, even when the industrial robot is arranged inside the EFEM housing while the base end side of the arm is adjacent to an inside side surface of the EFEM housing, pipes and cables can be routed along an inside side surface of the EFEM housing by using a space below the protruding portion in the present invention. Thus, in the present invention, even when the industrial robot is arranged having the base end side of the arm be adjacent to an inside side surface of the EFEM housing, flexibility in routing pipes and cables inside the EFEM housing can be increased in the present invention.

In said disclosure, it is preferred that the elevating unit be provided with a frame portion which is to be housed in the housing when the elevating unit is lowered, and a top side frame portion to which the protruding portion is formed, and that the frame portion and the top side frame portion be formed as separate bodies and fixed to each other. With this configuration, it is possible that multiple different top side frame portions having protruding portions with different protruding amounts can be secured to the common frame portion. Therefore, the protruding amount of the protruding portion of the elevating unit can be changed without changing the entire elevating unit, but by changing the top side frame portion only.

in said disclosure, the housing is formed to be in a rectangular shape having the longer direction in the left-right direction and the shorter direction in the front-rear direction when viewed from the top-bottom direction; the protruding portion is protruded toward one side in the front-rear direction.

In said disclosure, it is preferred that the main body unit be provided with an elevating mechanism for raising/lowering the elevating unit, that he elevating unit be provided with a frame portion which is formed to be in a rectangular shape having the longer direction in the left-right direction and the shorter direction in the front-rear direction when viewed from the top-bottom direction, and that the elevating mechanism be housed in the housing such that it aligns with the frame portion when viewed from the top-bottom direction. With this configuration, compared to the configuration in which that the elevating mechanism is stored while shifted from the frame portion in the front-rear direction, the width of the housing in the front-rear direction can be shortened. As a result, the main body unit can be made thinner.

In said disclosure, it is preferred that the main body unit be provided with a guide mechanism which has a guide rail and a guide block that engages with the guide rail to guide the elevating unit in the top-bottom direction, that the elevating unit be provided with a frame portion which is formed to be in a rectangular shape having the longer direction in the left-right direction and the shorter direction in the front-rear direction and is stored in the housing when the elevating unit is lowered, and that the guide rail and the guide block be arranged at both outsides of the frame portion in the left-right direction and accommodated inside the housing. With this configuration, the distance between the guide rail and the guide block arranged on the left side of the frame portion and the guide rail and the guide block arranged on the right side of the frame portion can be increased. Therefore, the elevating unit can smoothly be guided in the top-bottom direction by the guide mechanism.

### [Effects of the Invention]

As described above, in the industrial robot of the present invention, the main body portion to which the base end side of the arm is rotatably joined can be made thinner.

As described above, in the present invention, even when the industrial robot is arranged such that the base end side of the arm is placed adjacent to an inside side surface of the EFEM housing, flexibility in routing pipes and cables inside the EFEM housing can be increased.

### [Brief Description of the Drawing]

[Fig. 1] Perspective views of an industrial robot of an embodiment of the present invention: (A) illustrates that an elevating unit is lowered; (B) illustrates that the elevating unit is raised.
[Fig. 2] A side view of the industrial robot shown in Fig. 1.
[Fig. 3] A plan view of a semiconductor fabrication system in which the industrial robot shown in Fig. 1 is used.
[Fig. 4] A cross-sectional view used to explain the structure by an E-E cross-section of Fig. 2.

### [Detailed Description of the Invention]

An embodiment of the present invention is described hereinafter referring to the drawings.

### (Configuration of Industrial Robot)

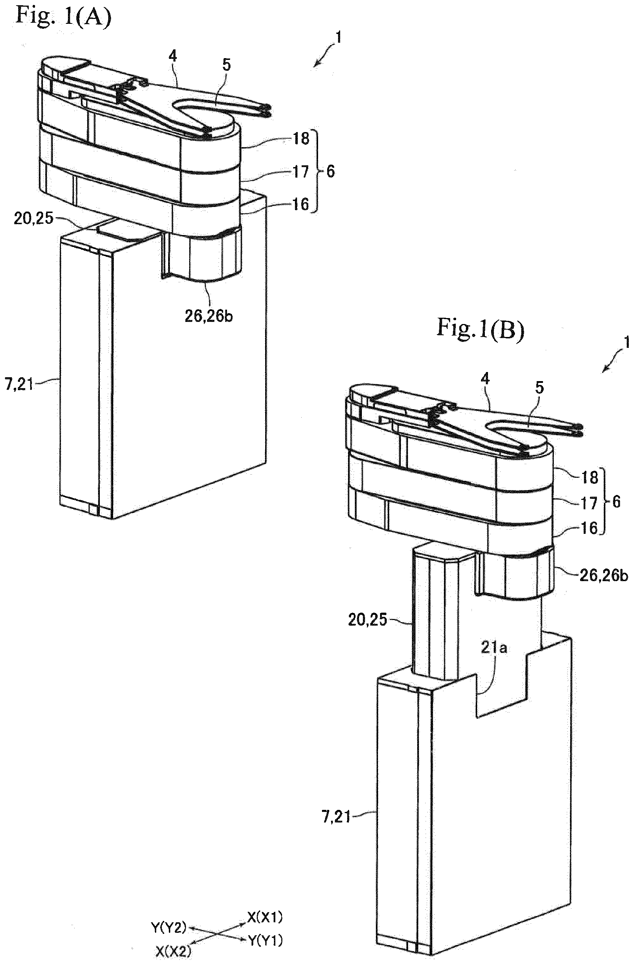

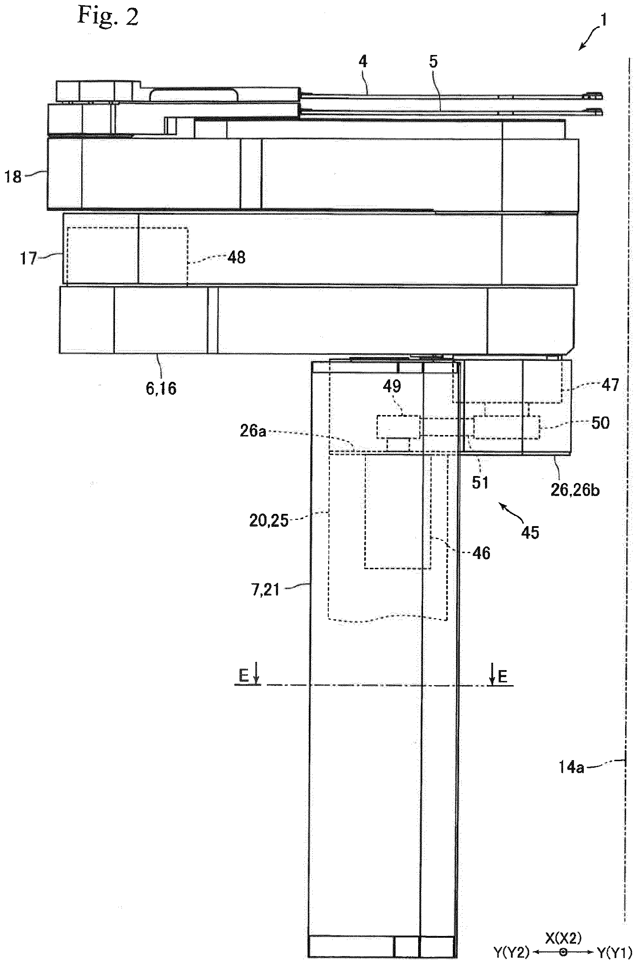

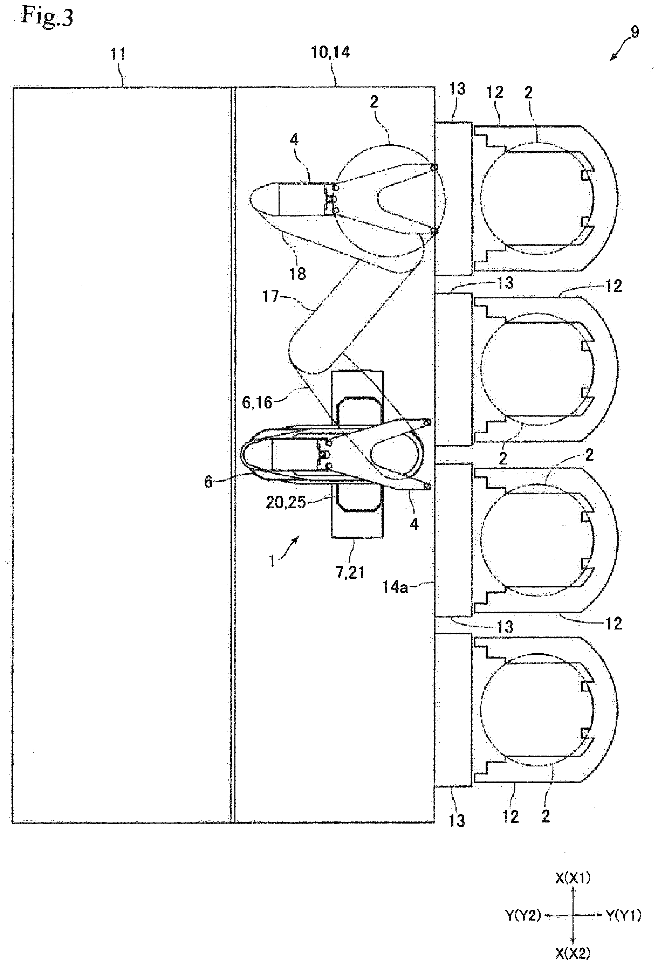

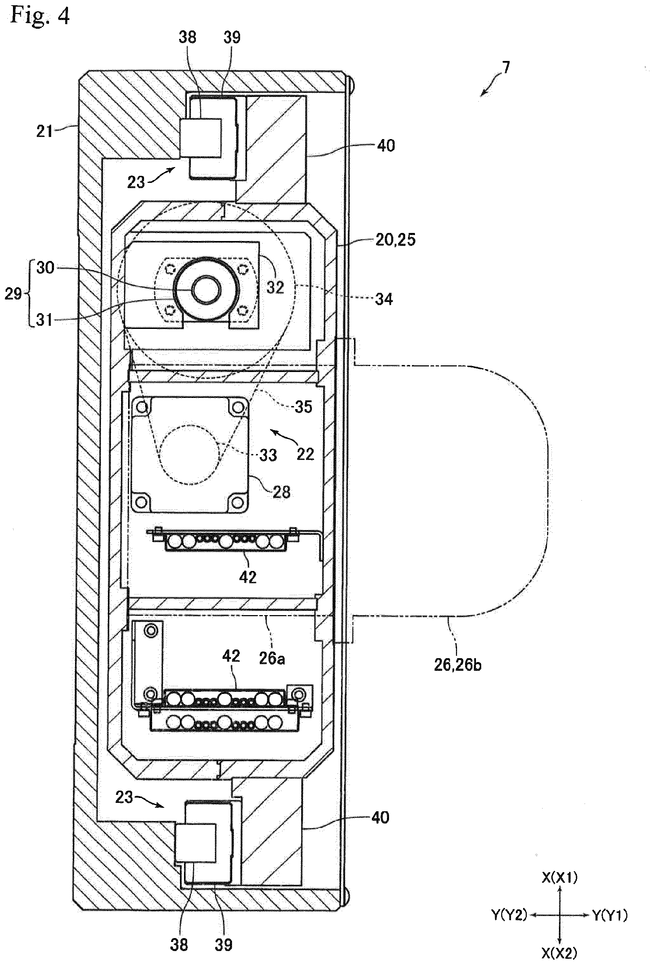

Fig. 1 shows perspective views of an industrial robot of an embodiment of the present invention: (A) illustrates [the robot] in a state where an elevating unit is lowered; (B) illustrates [the robot] in a state where the elevating unit is raised. Fig. 2 is a side view of the industrial robot shown in Fig. 1. Fig. 3 is a plan view of a semiconductor fabrication system in which the industrial robot shown in Fig. 1 is installed for use. Fig. 4 is a cross-sectional view used to explain the structure of an E-E cross-section of Fig. 2.

An industrial robot 1 of this embodiment is a horizontally articulated robot for transferring semiconductor wafers 2 (referring to Fig. 3) which are objects-to-be-transferred. This industrial robot 1 is provided with two hands 4, 5, on which semiconductor wafers 2 are to be mounted, an arm 6, to which the hands 4 and 5 are rotatably joined to the front end side thereof and moves horizontally, and a main body portion 7 to which the base end side of the arm 6 is rotatably joined. In the description below, the industrial robot 1 is noted as "robot 1" and the semiconductor wafer 2 is "wafer 2". Also, in the description below, the "left-right direction" is the X direction in Fig. 1, etc. which perpendicularly intersects with the top-bottom direction; the "front-rear direction: is the Y direction in Fig. 1, etc. which perpendicularly intersects with the top-bottom direction and the left-right direction; the X1 direction side is the "right" side; the X2 direction side is the "left" side; the Y1 direction side is the "front" side; the Y2 direction side is the "rear" side.

As shown in Fig. 3, the robot 1 is installed in a semiconductor fabrication system 9 for use. The semiconductor fabrication system 9 is equipped with an EFEM 10 and a semiconductor wafer processing device 11 for applying predetermined processing on wafers 2. The EFEM 10 is arranged on the front side of the semiconductor wafer processor 11. The robot 1 is part of the EFEM 10. Also, the EFEM 10 is equipped with multiple load ports 13 to open/close FOUPs 12 and a housing 14 in which the robot 1 is housed. The housing 14 is formed in a rectangular parallelepiped box elongated in the left-right direction. The load ports 13 are arranged on the front side of the housing 14. The robot 1 is placed inside the housing 14 such that the base end side of the arm 6 is positioned adjacent to the inside front surface 14a of the housing 14, and transfers wafers 2 between the FOUPs 12 and the semiconductor wafer processing device 11.

The arm 6 is configured by a first arm portion 16, which is rotatably joined to the main body portion 7 by the base end side thereof, a second arm portion 17, which is rotatably joined to the front end side of the first arm portion 16 by the base end side thereof, and a third arm portion 18, which is rotatably joined to the front end side of the second arm portion 17 by the base end side thereof. The first arm portion 16, the second arm portion 17 and the third arm portion 18 are formed hollow. The main body portion 7, the first arm portion 16, the second arm portion 17 and the third arm portion 18 are arranged in this order from the bottom in the top-bottom direction.

The [two] hands 4, 5 are formed to be in a Y-shape when viewed in the top-bottom direction. The base end portions of the hands 4 and 5 are joined to the front end side of the third arm portion 18. Also, the hands 4 and 5 are arranged to overlap in the top-bottom direction. More specifically described, the hand 4 is positioned at the top while the hand 5 is positioned at the bottom. The hands 4 and 5 are arranged above the third arm portion 18. Note that Fig. 3 omits the illustration of the hand 5.

The main body portion 7 is provided with an elevating unit 20 to which the base end side of the arm 6 is rotatably joined on the top surface side thereof, an housing 21 which holds the elevating unit 20 to be raised/lowered, an elevating mechanism 22 (referring to Fig. 4) for raising/lowering the elevating unit 20 with respect to the housing 21, and a guide mechanism 23 (referring to Fig. 4) for guiding the elevating unit 20 in the top-bottom direction.

The housing 21 is formed in a thin rectangular box shape; the shape of the housing 21 when viewed from the top-bottom direction is rectangular with the longer direction in the left-right direction and the shorter direction in the front-rear direction. More specifically described, the shape of the housing 21 when viewed in the top-bottom direction is rectangular elongated in the left-right direction. The front surface and the rear surface of the housing 21 are planar surfaces intersecting orthogonally with the front-rear direction; the left and right side surfaces of the housing 21 are planar surfaces intersecting orthogonally with the left-right direction. Also, the top surface and the bottom surface of the housing 21 are planar surfaces intersecting orthogonally with the top-bottom direction.

The elevating unit 20 is provided with a frame portion 25 formed to be a thin rectangular parallelepiped and a top side frame portion 26 fixed to the top end side of the frame portion 25. The frame portion 25 and the top side frame portion 26 are formed as separate bodies and secured to each other. More specifically, the frame portion 25 and the top side frame portion 26 are secured to each other by a screw whose illustration is omitted.

The frame portion 25 is formed in a box shape with an open bottom surface; the shape of the frame portion 25 when viewed from the top-bottom direction is a rectangular shape having the long direction in the left-right direction and the short direction in the front-rear direction. More specifically, the shape of the frame portion 25 when viewed from the top-bottom direction is a rectangular shape elongated in the left-right direction. The front surface and the back surface of the frame portion 25 are planar surfaces which orthogonally intersect with the front-rear direction, and the end surface on the left and right sides of the frame portion 25 are planar surfaces which orthogonally intersect with the left-right direction. Also, the top surface of the frame portion 25 is a planar surface which orthogonally intersects with the top-bottom direction.

The top side frame portion 26 are formed in a rectangular parallelepiped shape. The top side frame portion 26 is formed to be in a rectangular shape having the longer direction in the front-rear direction and the shorter direction in the left-right direction when viewed from the top-bottom direction. Also, the top side frame portion 26 is formed hollow. The width of the top side frame portion 26 in the left-right direction is shorter than the width of the frame portion 25 in the left-right direction. The top side frame portion 26 has a portion-to-be fixed 26a which is to be fixed to the frame portion 25. The portion-to-be-fixed 26a is accommodated in a recessed portion created in the center of the top end of the frame portion 25 in the left-right direction.

The top side frame portion 26 also has a protruding portion 26b which is connected with the front edge of the portion-to-be-fixed 26a and protrudes to the front side from the front surface of the frame portion 25. In other words, the elevating unit 20 is provided with the protruding portion 26b, which protrudes to the front side, on the top end thereof and with the top end side frame portion 26 to which the protruding portion 26b is formed. The base end side of the arm 6 is arranged on the top surface side of the protruding portion 26b and rotatably connected with the protruding portion 26b. In other words, the base end side of the first arm portion 16 is arranged on the top end side of the protruding portion 26b and rotatably connected with the protruding portion 26b.

When the elevating unit 20 is lowered, the frame portion 25 is accommodated in the housing 21. More specifically described, when the elevating unit 20 is lowered to the lowest position (that is, in the condition shown in Fig. 1 (A)), the frame portion 25 is entirely housed in the housing 21. In other words, when the elevating unit 20 is at the lowest position, most of the elevating unit 20, except the protruding portion 26b, is accommodated in the housing 21. Also, when the elevating unit 20 is elevated from the lowest position (that is, in the condition shown in Fig. 1 (B)), the bottom portion of the frame portion 25 remains in the housing 21. In the top end of the front surface of the housing 21, a notch portion 21a (referring to Fig. 1 (B)) is formed so that the protruding portion 26b is to be positioned when the elevating unit 20 is lowered. Note that a notch portion is formed in the top surface of the housing 21 for the frame portion 25 to pass through when the elevating unit 20 is raised or lowered.

The elevating mechanism 22 is housed in the housing 21. The elevating mechanism 22 is provided with a motor 28 and a ball screw 29, as shown in Fig. 4. The ball screw 29 has a screw shaft 30 which is to be driven by the force of the motor 28 and a nut 31 which engages with the screw shaft 30. The motor 28 is housed in the housing 21 and secured to the bottom side of the housing 21. Also, the motor 28 is positioned in the center of the housing 21 in the left-right direction. The screw shaft 30 is arranged such that the axial direction thereof coincides with the top-bottom direction. The screw shaft 30 is positioned on the right side of the motor 28. The screw shaft 30 is rotatably held by the housing 21.

The nut 31 is secured to a nut holding member 32. The nut holding member 32 is fixed inside the frame portion 25. In other words, the nut 31 is fixed inside the frame portion 25 via the nut holding member 32. A pulley 33 is secured to the output shaft of the motor 28, and a pulley 34 is secured to the bottom side of the screw shaft 30. A belt 35 is hung around the pulley 33 and the pulley 34. As shown in Fig. 4, the elevating mechanism 22 is housed in the housing 21 so as to align with the elevating unit 20 when viewed from the top-bottom direction. More specifically described, the elevating mechanism 22 is housed in the housing 21 so as to align with the frame portion 25.

The guide mechanism 23 is provided with a guide rail 38 and a guide block 39 which engages with the guide rail 38. The guide rail 38 is fixed inside the housing 21 such that the longer direction thereof aligns with the top-bottom direction. Also, the guide rail 38 is fixed to the left and right ends on the inside of the housing 21. The guide block 39 is fixed to a block holding member 40. The block holding member 40 is secured to the left and right side surfaces of the frame portion 25. In other words, the guide block 39 is secured to the left and right side surfaces of the frame portion 25 via the block holding member 40, and the guide rail 38 and the guide block 39 are arranged at the left and right sides on the outside of the frame portion 25. Also, the guide rail 38 and the guide block 39 are housed in the housing 21.

In this embodiment, when the motor 28 rotates, the elevating unit 20 moves up and down with respect to the housing 21 while guided by the guide mechanism 23. Note that one end of a cableveyor (registered trade mark) 42 is secured inside the frame portion 25, and the other end of the cableveyor (registered trade mark) 42 is secured inside the housing 21. The cableveyor (registered trade mark) 42 is positioned on the left side of the motor 28.

The robot 1 is also provided with an arm portion driving mechanism 45 (referring to Fig. 2) which rotates the first arm portion 16 and the second arm portion 17 to extend/retract part of the arm 6 which is configured by the first arm portion 16 and the second arm portion 17, a third arm portion driving mechanism (illustration omitted) for rotating the third arm portion 18, a hand driving mechanism (illustration omitted) for rotating the hand 4, and a hand driving mechanism (illustration omitted) for rotating the hand 5.

As shown in Fig. 2, the arm driving mechanism 45 has a motor 46, a reduction gear 47 which reduces the force of the motor 46 and transmits it to the first arm portion 16, and a reduction gear 48 which reduces the force of the motor 46 and transmits it to the second arm portion 17. The motor 46 is fixed to the bottom surface of the portion-to-be-fixed 26a of the top end side frame portion 26. More specifically, the motor 46 is fixed on the bottom surface of the portion-to-be-fixed 26a such that the output shaft thereof is positioned inside the portion-to-be-fixed 26a and the main body portion of the motor 46 is positioned inside the frame portion 25.

The reduction gear 47 configures a joint portion which connects the first arm portion 16 and the protruding portion 26b. This reduction gear 47 is a hollow reduction gear. The case body of the reduction gear 47 is secured inside the protruding portion 26b. The top surface of the output shaft of the reduction gear 47 is fixed to the bottom surface on the base end side of the first arm portion 16. The reduction gear 47, except a top portion of the output shaft which is fixed to the bottom surface of the base end side of the first arm portion 16, is housed inside the protruding portion 26b. The motor 46 and the reduction gear 47 are connected with each other via the pulley 49, which is fixed to the output shaft of the motor 46, a pulley 50, which is fixed to the input shaft of the reduction gear 47, and a belt 51 which is hung around the pulley 49 and the pulley 50. The pulleys 49 and 50 and the belt 51 are housed inside the top side frame portion 26.

The reduction gear 48 configures a joint portion that connects the first arm portion 16 and the second arm portion 17. The reduction gear 48 is a hollow reduction gear, like the reduction gear 47. The motor 46 and the reduction gear 48 are connected with one another via the pulleys 49 and 50, the belt 51, and a pulley, belt, etc. arranged inside the first arm portion 16.

A third arm portion driving mechanism has a motor and a reduction gear which reduces the force of the motor and transmits it to the third arm portion 18. The motor of the third arm portion driving mechanism is arranged inside the second arm portion 17; the reduction gear of the third arm portion driving mechanism configures a joint portion that connects the second arm portion 17 and the third arm portion 18. A hand driving mechanism has a motor and a reduction gear which reduces the force of the motor and transmits it to the hands 4 and 5. The motor and the reduction gear of the hand driving mechanism are arranged inside the third arm portion 18. The reduction gear of the hand driving mechanism and the hands 4 and 5 are connected with one another via a pulley and a belt which are omitted in the figures.

### (Major Effects of This Embodiment)

In this embodiment, as described above, the elevating mechanism 22 is accommodated in the housing 21 such that it aligns with the frame portion 25 in the housing 21 when viewed in the top-bottom direction. Therefore, compared to the configuration in which the elevating mechanism 22 is housed in the housing 21 while shifted from the frame portion in the front-rear direction, the width of the housing 21 in the front-rear direction can be shortened in this embodiment. In other words, compared to the configuration in which the elevating mechanism 22 is housed in the housing 21 while shifted from the frame portion in the front-rear direction, the width of the main body portion 7 in the front-rear direction can be shortened in this embodiment; as a result, the main body portion 7 can be made thinner.

In this embodiment, the frame portion 25 is formed to be in a rectangular shape elongated in the left-right direction when viewed from the top-bottom direction; the guide rail 38 and the guide block 39 are arranged on the outsides of the frame portion 25 in the left-right direction. Therefore, it is possible in this embodiment to increase the distance between the guide rail 38 and the guide block 39 which are positioned on the left side of the frame portion 25 and the guide rail 38 and the guide block 39 which are positioned on the right side of the frame portion 25. Therefore, the elevating unit 20 can smoothly be guided in the top-bottom direction by the guide rail 38 and the guide block 39.

In this embodiment, as described above, the elevating unit 20 has the protruding portion 26b, which protrudes to the front side, on the top side thereof; the base end side of the arm 6 is rotatably connected to the protruding portion 26b. Therefore, even when the robot 1 is arranged inside the housing 14 such that the base end side of the arm 6 is positioned adjacent to the inside front surface 14a of the housing 14 of the EFEM 10 as shown in Fig. 3, pipes and cables to be routed inside the housing 14 can be routed along the front surface 14a of the housing 14 by using a space at the bottom of the protruding portion 26b (see Fig. 2). Therefore, in this embodiment, even when the robot 1 is arranged inside the housing 14 such that the base end side of the arm 6 is positioned adjacent to the front surface 14a of the housing 14, flexibility in routing pipes and cables inside the housing 14 can be increased.

In this embodiment, the frame portion 25 and the top side frame portion 26 are formed as separate bodies and fixed to each other. Therefore, in this embodiment, multiple top side frame portions 26, each of which has the protruding portion 26b with the protruding mount can be fixed to the single frame portion 25. Therefore, in this embodiment, the elevating unit 20 does not have to be replaced entirely, but [only] the top side frame portion 26 and the belt 51 are replaced to change the protruding amount of the protruding portion 26b.

In this embodiment, the elevating mechanism 22 is accommodated in the housing 21 so as to align with the frame portion 25, which is accommodated in the housing 21, when viewed from the top-bottom direction. Therefore, compared to the configuration in which the elevating mechanism 22 is housed in the housing 21 while shifted from the frame portion 25 in the front-rear direction, the width of the housing 21 in the front-rear direction can be shortened in this embodiment; as a result, the main body portion 7 can be made thinner.

In this embodiment, the frame portion 25 is formed to be in a rectangular shape elongated in the left-right direction when viewed from the top-bottom direction; the guide rail 38 and the guide block 39 are arranged on the left and right sides of the frame portion 25. Therefore, in this embodiment, the distance between the guide rail 38 and the guide block 39 which are arranged on the left side of the frame portion 25 and the guide rail 38 and the guide block 39 arranged on the right side of the frame portion 25 can be increased. Therefore, the elevating unit 20 can smoothly be guided in the up- down direction by the guide rail 38 and the guide block 39 in this embodiment.

### (Other Embodiments)

The above-descried embodiment is an example of a preferred embodiment of the present invention; however, it is not limited to this, but can be varyingly modified within the scope of the claims.

In the above-described embodiment, the protruding portion 26b protrudes to the front side from the front surface of the frame portion 25; however, the protruding portion 26b may protrude to the back from the rear surface of the frame portion 25. In this case, the robot 1 is positioned inside the housing 14 such that the base end side of the arm 6 is adjacent to the inside rear surface of the housing 14 of the EFEM 10. In the above-described embodiment, also, the housing 21 and the frame portion 25 are formed to be in a rectangular shape elongated in the left-right direction when viewed from the top-bottom direction; however, the housing 21 and the frame portion 25 may be formed to be in a polygonal shape other than a square or quadrangle shape, or a circular shape when viewed from the top-bottom direction.

In the above-described embodiment, the frame portion 25 and the top side frame portion 26 are formed as separate bodies and fixed to each other; however, the frame portion 25 and the top side frame portion 26 may be formed as a single unit. In other words, the protruding portion 26b may be formed directly to the frame portion 25. Also, in the above-described embodiment, the elevating mechanism 22 is housed in the housing 21 so as to align with the frame portion 25 housed in the housing 21 when viewed from the top-bottom direction; however, the elevating mechanism 22 may be housed in the housing 21 while shifted from the frame portion 25 in the front-rear direction or may be housed in the housing 21 while shifted from the frame portion 25 in the left-right direction.

In the above-described embodiment, the frame portion 25 is entirely housed in the housing 21 when the elevating unit 20 is lowered to the lowest position; however, the top end portion of the frame portion 25 may protrude toward the top from the top surface of the housing 21 when the elevating unit 20 is lowered at the lowest position. Also, in the above-described embodiment, the elevating unit 20 has the protruding portion 26b, which protrudes to the front side; however, the elevating unit 20 may not have the protruding portion 26b. Also, the robot 1 of the above-described embodiment may be provided with an elevating mechanism for raising/lowering the main body portion 7 (more specifically, for raising/lowering the housing 21). In other words, the robot 1 may be provided with the same elevating mechanism as the elevating mechanism disclosed in Unexamined Japanese Patent Application 2015-36185 Publication.

In the above-described embodiment, the two hands 4 and 5 are attached to the front end side of the third arm portion 18; however, [only] one hand may be attached to the front end side of the third arm portion 18. Also, in the above-described embodiment, the arm 6 is configured by three arm portions: the first arm portion 16, the second arm portion 17 and the third arm portion 18; however, the arm 6 may be configured by two arm portions or four or more arm portions. In the above-described embodiment, the robot 1 is a robot for transferring wafers 2; however, the robot 1 may be a robot for transferring objects-to-be-transferred such as liquid crystal glass substrates.

## Claims

1. An industrial robot (1), comprising:
hands (4, 5) on which objects-to-be-transferred (2) are to be mounted;
an arm (6) to which said hands (4, 5) are rotatably joined with the front end side thereof; and
a main body portion (7) to which the base end side of said arm (6) is rotatably joined;
wherein said main body portion (7) is provided with an elevating unit (20) to which the base end side of said arm (6) is rotatably joined on the top surface side thereof, a housing (21) which holds said elevating unit (20) to be raised/lowered and in which at least part of the bottom end of said elevating unit (20) is housed, and an elevating mechanism (22) for raising/lowering said elevating unit (20);
said elevating mechanism (22) is provided with a motor (28), a ball screw (29), a first pulley (33) secured to an output shaft of the motor (28), a second pulley (34) secured to a screw shaft (30) of the ball screw (29), and a belt (35) hung around the first pulley (33) and the second pulley (34), and is accommodated in said housing (21) such that it is to align with said elevating unit (20) when viewed from the top-bottom direction; the industrial robot (1) **characterized in that**
the motor (28) is positioned in the center of the housing (21) in the left-right direction (X), and the screw shaft (30) is positioned on the right side of the motor (28), and that
the motor (28) and the ball screw (29) are positioned in the housing (21) so as to be adjacent to each other in the left-right direction (X).

2. The industrial robot (1) as set forth in Claim 1 wherein
said housing (21) is formed to be a rectangular shape having the longer direction in the left-right direction (X) and the shorter direction in the front-rear direction (Y) when viewed from the top-bottom direction;
said elevating unit (20) is formed to be a rectangular shape having the longer direction in the left-right direction (X) and the shorter direction in the front-rear direction (Y) when viewed from the top-bottom direction, and is provided with a frame portion (25) which is housed in said housing (21) when said elevating unit (20) is lowered.

3. The industrial robot (1) as set forth in Claim 2 wherein
said main body portion (7) is provided with a guide mechanism (23) which has a guide rail (38) and a guide block (39) engaged with said guide rail (38) and guides said elevating unit (20) in the top-bottom direction; and
said guide rail (38) and said guide block (39) are arranged at left and right sides of said frame portion (25) and housed inside said housing (21).

## Patentansprüche

1. Industrieroboter (1), umfassend:
Hände (4, 5), an denen zu transportierende Gegenstände (2) zu befestigen sind;
einen Arm (6), an dem die Hände (4, 5) drehbar mit der vorderen Endseite davon verbunden sind; und
einen Hauptkörperabschnitt (7), mit dem die Basisendseite des Arms (6) drehbar verbunden ist;
wobei der Hauptkörperabschnitt (7) mit einer Hebeeinheit (20), mit der die Basisendseite des Arms (6) an dessen oberer Flächenseite drehbar verbunden ist, einem Gehäuse (21), das die anzuhebende/abzusenkende Hebeeinheit (20) hält und in dem zumindest ein Teil des unteren Endes der Hebeeinheit (20) untergebracht ist, und einem Hebemechanismus (22) zum Anheben/Absenken der Hebeeinheit (20) versehen ist;
wobei der Hebemechanismus (22) mit einem Motor (28), einer Kugelumlaufspindel (29), einer ersten Riemenscheibe (33), die an einer Ausgangswelle des Motors (28) befestigt ist, einer zweiten Riemenscheibe (34), die an einer Spindelwelle (30) der Kugelumlaufspindel (29) befestigt ist, und einem Riemen (35), der um die erste Riemenscheibe (33) und die zweite Riemenscheibe (34) herumgehängt ist, versehen ist und in dem Gehäuse (21) so untergebracht ist, dass er mit der Hebeeinheit (20) in der Richtung von oben nach unten gesehen ausgerichtet ist; wobei der Industrieroboter (1), **dadurch gekennzeichnet, dass**
der Motor (28) in der Mitte des Gehäuses (21) in der Links-Rechts-Richtung (X) angeordnet ist und die Spindelwelle (30) auf der rechten Seite des Motors (28) angeordnet ist, und dass
der Motor (28) und die Kugelumlaufspindel (29) in dem Gehäuse (21) in Links-Rechts-Richtung (X) benachbart zueinander angeordnet sind.

2. Industrieroboter (1) gemäß Anspruch 1, wobei
das Gehäuse (21) so ausgebildet ist, dass es eine rechteckige Form mit der längeren Richtung in der Links-Rechts-Richtung (X) und der kürzeren Richtung in der Vorne-Hinten-Richtung (Y) hat, wenn man es von der Oben-Unten-Richtung betrachtet;
die Hebeeinheit (20) so ausgebildet ist, dass sie eine rechteckige Form mit der längeren Richtung in der Links-Rechts-Richtung (X) und der kürzeren Richtung in der Vorne-Rückwärts-Richtung (Y) aufweist, wenn sie von der Oben-Unten-Richtung aus betrachtet wird, und mit einem Rahmenabschnitt (25) versehen ist, der in dem Gehäuse (21) untergebracht ist, wenn die Hebeeinheit (20) abgesenkt ist.

3. Industrieroboter (1) gemäß Anspruch 2, wobei
der Hauptkörperabschnitt (7) mit einem Führungsmechanismus (23) versehen ist, der eine Führungsschiene (38) und einen Führungsblock (39) aufweist, der mit der Führungsschiene (38) in Eingriff steht und die Hebeeinheit (20) in der Richtung von oben nach unten führt; und
die Führungsschiene (38) und der Führungsblock (39) an der linken und rechten Seite des Rahmenabschnitts (25) angeordnet sind und innerhalb des Gehäuses (21) untergebracht sind.

## Revendications

1. Un robot industriel (1), comprenant :
des mains (4, 5) sur lesquelles les objets à transférer (2) doivent être montés ;
un bras (6) auquel lesdites mains (4, 5) sont reliées de manière rotative avec leur côté d'extrémité avant ; et
une partie (7) de corps principal à laquelle le côté d'extrémité de base dudit bras (6) est relié de manière rotative ;
ladite partie (7) de corps principal est dotée d'une unité d'élévation (20) à laquelle le côté extrémité de base dudit bras (6) est relié de manière rotative sur le côté surface supérieure de celui-ci, un boîtier (21) qui maintient ladite unité d'élévation (20) à élever/abaisser et dans lequel est logée au moins une partie de l'extrémité inférieure de ladite unité d'élévation (20), et un mécanisme élévateur (22) pour élever/abaisser ladite unité d'élévation (20) ;
ledit mécanisme élévateur (22) est pourvu d'un moteur (28), d'une vis à billes (29), d'une première poulie (33) fixée à un arbre de sortie du moteur (28), d'une deuxième poulie (34) fixée à un arbre en vis (30) de la vis à billes (29), et une courroie (35) accrochée autour de la première poulie (33) et de la deuxième poulie (34), et est logée dans ledit boîtier (21) de telle sorte qu'elle soit alignée avec ladite unité élévatrice (20), lorsqu'elle est vue depuis la direction haut-bas ; le robot industriel (1) **caractérisé en ce que**
le moteur (28) est positionné au centre du boîtier (21) dans la direction gauche-droite (X), et l'arbre à vis (30) est positionné sur le côté droit du moteur (28), et **en ce que**
le moteur (28) et la vis à billes (29) sont positionnées dans le boîtier (21) de manière à être adjacentes l'une à l'autre dans la direction gauche-droite (X).

2. Le robot industriel (1) selon la revendication 1, dans lequel
ledit boîtier (21) est formé pour avoir une forme rectangulaire ayant la direction la plus longue dans la direction gauche-droite (X) et la direction la plus courte dans la direction avant-arrière (Y) lorsqu'on le regarde depuis la direction haut-bas ;
ladite unité d'élévation (20) est formée pour avoir une forme rectangulaire ayant la direction la plus longue dans la direction gauche-droite (X) et la direction la plus courte dans la direction avant-arrière (Y) lorsqu'elle est vue depuis la direction haut-bas, et est pourvu d'une partie formant châssis (25) qui est logée dans ledit boîtier (21) lorsque ladite unité élévatrice (20) est abaissée.

3. Le robot industriel (1) selon la revendication 2, dans lequel
ladite partie (7) de corps principal est dotée d'un mécanisme de guidage (23) qui possède un rail de guidage (38) et un bloc de guidage (39) qui est en prise avec ledit rail de guidage (38) et qui guide ladite unité d'élévation (20) dans la direction haut-bas ; et
ledit rail de guidage (38) et ledit bloc de guidage (39) sont agencés sur les côtés gauche et droit de ladite partie formant châssis (25) et logés à l'intérieur dudit boîtier (21).
